# FASCICULE DE BREVET EUROPEEN

(11) **EP 2 463 686 B1**
(45) Date de publication et mention de la délivrance du brevet: **04.04.2018**
(21) Numéro de dépôt: 11191497.4
(22) Date de dépôt: 01.12.2011
(51) Int. Cl.: G01T 1/29

(54) **Dispositif et procédé pour anlyser la densité d'un faisceau de particules chargées**
Vorrichtung und Verfahren zum Analysieren der Dichte eines Strahls aus geladenen Teilchen
Device and method for analysing the density of a beam of charged particles

(30) Priorité: 07.12.2010 FR 1060194
(43) Date de publication de la demande: 13.06.2012
(73) Titulaire: TECHMETA ENGINEERING SAS, 69800 Saint-Priest (FR)
(72) Inventeur: Oving, Peter Johan, 38340 VOREPPE (FR)
(74) Mandataire: Mazabraud, Xavier

(56) Documents cités:
- WO-A1-01/51183
- US-A- 4 628 209
- US-A1- 2002 079 465

## Description

La présente invention se rapporte au domaine des appareils de mesure, particulièrement des appareils pour mesurer le diamètre et la forme d'un faisceau d'ions ou d'électrons, notamment dans des outils tels qu'un implanteur d'ions ou un appareil pour la soudure par faisceau d'électrons.

Les machines de faisceau d'électrons ont trouvé des applications variées, en particulier dans le domaine de la soudure, de la modification de surface, de la génération de rayon X, de la lithographie de faisceau d'électrons, de la microscopie électronique, et dans bien d'autres domaines encore. Avec ces applications est venu le besoin de commande précise de la focalisation et de l'alignement du faisceau, aussi bien qu'un besoin particulier de déterminer la distribution d'énergie dans un faisceau d'électrons.

La production de faisceaux reproductibles d'électrons peut être réalisée indépendamment de la machine ou de l'opérateur si la distribution d'énergie de faisceau peut être contrôlée et connue avec précision. Les méthodes conventionnelles pour le réglage de la distribution d'énergie se basent sur le savoir faire d'un opérateur spécialiste en soudure qui règle visuellement le faisceau sur une cible secondaire. L'opérateur regarde l'intensité du rayonnement de la lumière dégagée plutôt qu'une mesure directe de la distribution d'énergie du faisceau. Cette méthode ancienne est en soi imprécise, exigeant un opérateur expérimenté et un jugement précis pour réaliser la focalisation juste du faisceau. Il est clair que chaque opérateur peut régler les paramètres différemnent en fonction de l'interprétation que chacun peut faire de ce qu'il voit.

La densité de courant en question est influencée par beaucoup de variables, comme la forme de la cathode, les réglages de focalisation, la distance de tir, la valeur du courant, la tension d'accélération, le niveau du vide et l'alignement des électrodes. Une variation de ces paramètres peut occasionner une variation de la répartition de la densité de courant du faisceau, ce qui peut avoir un effet significatif sur la pénétration de la soudure, la largeur du cordon de la soudure et la qualité de la surface des objets soudés par faisceau d'électrons. Un dispositif conventionnel est connu de US 4,628,209. Les méthodes conventionnelles pour régler le faisceau ne sont pas entièrement satisfaisantes. Divers appareils ont été développés pour déterminer diverses caractéristiques des faisceaux d'électrons ou d'ions, tels que la configuration du faisceau, le diamètre, l'énergie maximale, la largeur du faisceau, la densité de courant, etc. parmi les différentes appareils, la sonde à fil tournant, les dispositifs à trou d'épingle, la cage de Faraday modifiée, la cage de Faraday modifiée et améliorée, le scanner à double disques fendus tournants.

Ces moyens de diagnostique quantitatif étaient destinés à mieux déterminer la distribution de la densité de courant et donc par ce biais de mieux contrôler les conditions de la focalisation du faisceau. Pour obtenir l'image la plus réaliste de la densité de courant du faisceau d'électrons, le faisceau devra idéalement se trouver au repos sans balayage par-dessus un outil d'analyse (ce balayage est pourtant utilisé avec les outils de type fil tournant et la cage de Faraday modifiée et améliorée).

L'invention a pour but de proposer un dispositif et une méthode pour analyser un faisceau de particules chargées, notamment un faisceau d'électron ou d'ions, permettant de déterminer la distribution de la densité de courant, donc de puissance, dans une section du faisceau. En outre, l'invention a pour but de proposer une solution n'utilisant pas de reconstruction tomographique.

Selon un premier objet de l'invention, un tel dispositif pour l'analyse de la densité de courant dans un faisceau incident de particules chargées est caractérisé tel que décrit dans la revendication 1. Selon l'invention, la cible est mobile en rotation autour d'un axe, et le parcours de chaque trou est un arc de cercle centré sur l'axe. La cible comprend avantageusement au moins un trou repère, la section du trou repère étant notablement différente, de préférence double, de la section de l'au moins un trou. La cible comprend plusieurs trous, les arcs de cercles parcourus par les trous étant de préférence régulièrement radialement espacés entre eux. Les arcs de cercles parcourus par les trous sont radialement plus proches dans une zone intermédiaire et radialement plus éloignés de part et d'autre de ladite zone intermédiaire. Les trous peuvent être régulièrement angulairement espacés entre eux, ou pas.

De préférence, les moyens pour mesurer la densité de courant de la fraction comprennent au moins une cage de Faraday.

Le dispositif peut aussi comprendre une cible d'amorçage, de préférence refroidie. Le dispositif peut alors comprendre des moyens pour défléchir le faisceau à analyser, incident, en direction de la cible d'amorçage.

Selon un deuxième objet de l'invention, un procédé d'analyse de la densité de courant dans une section d'un faisceau incident de particules chargées est tel que décrit dans la revendication 7. Pour mesurer le profil, on fait tourner une cible percée de plusieurs trous. La cible est une cible, tournante autour d'un axe percée, comprenant plusieurs trous, les trous étant de préférence régulièrement répartis, radialement et/ou angulairement, relativement à l'axe, les trous ayant une section identique entre eux. La cible comprend avantageusement un trou repère ayant une section différente de celle des autres trous, de sorte que le parcours dudit repère dans la section analysée provoque une anomalie dans le profil, de sorte que l'on vérifie que l'analyse est complète en s'assurant que deux anomalies apparaissent dans le profil. L'apparition de deux anomalies successives peut être utilisée pour déterminer la vitesse de rotation réelle de la cible durant l'analyse.

Le procédé selon l'invention peut en outre comprendre des étapes pour:
- positionner le faisceau (F), de préférence défocalisé, à faible courant et non défléchi, sur la cible (2), ladite cible (2) étant une cible tournante; puis,
- défléchir le faisceau en direction d'une cible d'amorçage (9); puis,
- augmenter la puissance du faisceau jusqu'à atteindre sa puissance nominale et un équilibre thermique dudit faisceau; puis,
- lorsque la vitesse de rotation de la cible tournante (2) est stabilisée, arrêter la déflection du faisceau; et,
- acquérir le profil pendant un temps donné, de préférence correspondant sensiblement à deux révolution de cible (2); puis,
- défléchir de nouveau le faisceau en direction de la cible d'amorçage (9); puis,
- éteindre le faisceau et arrêter la rotation de la cible (2).

Le procédé peut aussi comprendre au moins une étape pour calculer au moins un paramètre du faisceau parmi la largeur à mi-hauteur, la largeur à la hauteur 1/e², la puissance surfacique maximale.

Un tel procédé peut être utilisé dans un procédé pour déterminer une usure d'une électrode d'un générateur de faisceau de particules chargées.

Un tel procédé peut aussi être utilisé dans un procédé pour déterminer un défaut d'alignement d'une électrode d'un générateur de faisceau de particules chargées.

Un tel procédé peut aussi être utilisé pour déterminer une focalisation optimale du faisceau.

Plusieurs modes d'exécution de l'invention seront décrits ci-après, à titre d'exemples non limitatifs, en référence aux dessins annexés dans lesquels :
- la figure 1 est une vue schématique en perspective d'un premier mode de réalisation pour un dispositif selon l'invention destiné à mesurer des intensités d'un faisceau de particules chargées au travers d'une section de ce faisceau, dispositif comprenant une plaque tournante munie de "trous d'aiguilles";
- la figure 2 est une demi-coupe partielle et schématique du dispositif de la figure 1, au droit d'une cage de Faraday, le faisceau y étant représenté traversant l'un des trous d'aiguilles;
- la figure 3 illustre les valeurs d'un signal mesuré avec le dispositif de la figure 1, au cours de deux révolutions de la plaque;
- la figure 4 illustre des valeurs, extraites de celles de la figure 3, correspondant à une seule révolution de la plaque;
- la figure 5 illustre des valeurs corrigées extraites des valeurs de la figure 4;
- la figure 6 est une représentation des valeurs de la figure 5 en fonction de leur position relativement à la section du faisceau;
- la figure 7 illustre une reconstruction spatiale, en trois dimensions et en courbes de niveau de la répartition de l'intensité du faisceau selon sa section, déduite de celle de la figure 6;
- La figure 8 est une vue semblable à celle de la figure 1, d'un deuxième mode de réalisation d'un dispositif selon l'invention, lequel comprend deux cages de Faraday;
- les figures 9 et 10 illustrent des parcours au droits de chacune des cages de Faraday du dispositif de la figure 8;
- la figure 11 illustre une superposition des parcours de figures 9 et 10; et,
- la figure 12 illustre une reconstruction spatiale à partir de mesures effectuées avec le dispositif de la figure 8.

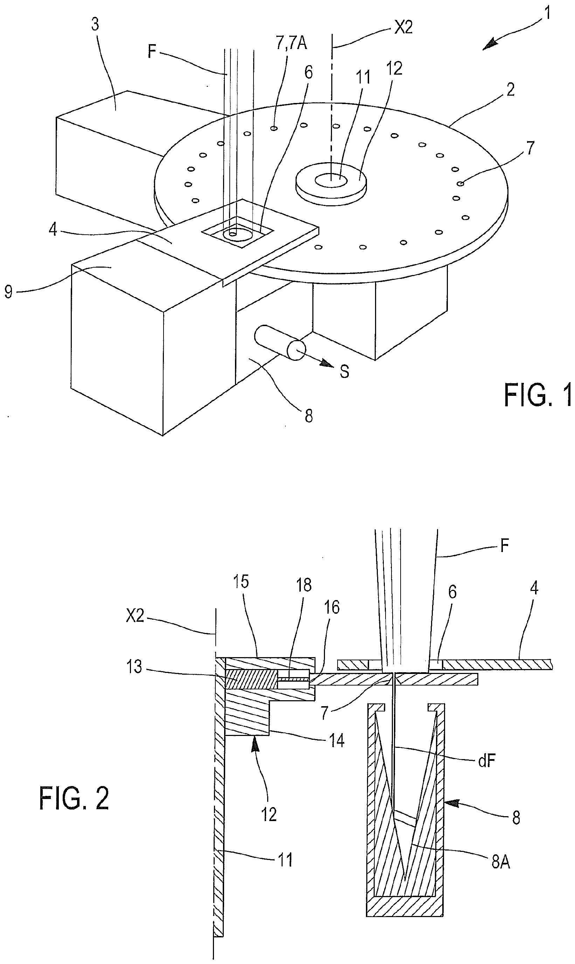

La figure 1 illustre un dispositif 1 selon l'invention, prévu pour l'analyse d'un faisceau F de particules chargées. Dans l'exemple illustré, le faisceau F est un faisceau d'électrons.

Dans l'exemple illustré aux figures 1 et 2, le faisceau F est supposé tiré verticalement du haut vers le bas. Les positions relatives des éléments du dispositif sont donc données en fonction de cette hypothèse. Bien entendu, le même dispositif peut prendre d'autres positions, fonctions des directions de tir de faisceaux à analyser.

Dans l'exemple illustré, le dispositif 1 comprend une cible motorisée 2, et un moteur 3 pour mouvoir cette cible. Le dispositif comprend en outre une fenêtre 4, au travers d'une ouverture 6 de laquelle le faisceau est tiré, une cage de Faraday 8 pour recevoir une partie filtrée dF du faisceau F, et, une cible secondaire d'amorçage 9.

La cible motorisée 2 est essentiellement constituée d'une plaque 2 en forme de disque. Le disque 2 est monté tournant autour d'un axe de révolution X2. L'axe X2 est sensiblement confondu avec l'axe géométrique du disque. L'axe X2 est disposé sensiblement parallèlement à la direction de tir du faisceau F, c'est-à-dire sensiblement verticalement. Le moteur 3 est prévu pour entraîner le disque 2 en rotation autour de l'axe X2. Le moteur 3 est en outre prévu pour une rotation de la cible 2 à vitesse constante durant l'analyse du faisceau F.

La fenêtre 4 forme une ouverture 6, au dessus de la cible 2, au voisinage de la périphérie du disque. La fenêtre 4 forme autour de l'ouverture 6 une protection pour la cible 2 lorsque le faisceau n'est pas en position d'être analysé, c'est-à-dire lorsque le faisceau n'est pas dirigée verticalement dans l'espace délimité par l'ouverture 6.

La cible est percée de "trous d'aiguilles" 7, c'est-à-dire qu'elle est percée de trous traversants 7 de petites dimensions relativement au diamètre du faisceau F à analyser. Dans l'exemple illustré, les trous 7 sont régulièrement disposés, de sorte qu'au cours d'une rotation complète de la cible 2, chacun parcourt l'ouverture 6 selon un arc de cercle qui lui est propre, les arcs de cercles étant radialement espacés entre eux, de façon régulière, c'est-à-dire que la distance entre deux arcs voisins est constante. Dans l'exemple illustré, les dimensions de l'ouverture sont telles que les arcs de cercle peuvent éventuellement être assimilés à des segments de droite si la précision demandée n'est pas trop importante. Les trous sont aussi angulairement espacés de façon régulière, c'est-à-dire que l'angle, relativement à l'axe X2, entre deux trous successifs est constant. De préférence, les trous sont régulièrement répartis sur 360 degrés autour de l'axe X2. Ainsi, les orifices 7 sont disposés selon une forme de spirale. Les trous sont avantageusement disposés de sorte que jamais plus d'un trou 7 ne parcourt l'ouverture 6 simultanément. En particulier, la taille de l'ouverture 6 est choisie de façon à ce que le faisceau analysé ne voit qu'un seul trou en rotation à la fois.

Tous les trous 7 sont de sections horizontales circulaires et sensiblement identiques entre eux, sauf un orifice 7A. L'orifice 7A est un trou formant repère. Il a des dimensions différentes de celles des autres trous, de sorte qu'il fournit une indication de la position relative de la cible 2 relativement au faisceau, à chaque fois que ce trou 7A parcourt l'ouverture 6. Ainsi, si le repère 7A a une section notablement supérieure à celle des autres trous 7, il recevra aussi une quantité d'électrons notablement supérieure. Par exemple, si le repère a une section d'entrée double de celle des autres trous, il recevra une quantité d'électrons sensiblement double de celle attendue. Dans l'exemple illustré les dimensions du repère 7A diffèrent de celle des autres trous en ce qu'elles sont doublées selon la direction de l'arc correspondant. De préférence le repère est disposé de sorte qu'il parcourt une région centrale de la fenêtre. On évite ainsi qu'il parcoure une région périphérique, peu significative, de faible intensité, ou absente du faisceau analysé.

La rotation de la cible 2 permet de répartir sur une grande surface l'énergie transmise à la cible par le faisceau F durant les mesures. Néanmoins, le matériau utilisé pour le disque est très avantageusement de type réfractaire. Il peut notamment être réalisé en tungstène, en molybdène ou en graphite. S'il est en graphite, il peut ne comporter que du graphite ou comprendre sur sa face supérieure une incrustation ou une projection d'un métal réfractaire tel le tungstène ou le molybdène. L'incrustation ou la projection d'un métal réfractaire conduit à l'augmentation du nombre d'électrons secondaires (« électrons rebondissant » de la surface) réduisant ainsi la charge thermique du disque, ce qui permet l'utilisation du dispositif 1 pour analyser des faisceaux F de puissances plus élevées.

Avantageusement, le dispositif est équipé d'un collecteur de courant (non représenté aux figures) de type charbon en contact avec la cible, pour évacuer en permanence le courant intercepté au cours de l'analyse.

Comme particulièrement illustré à la figure 2, la cible 2 est fixée sur un arbre 11 d'axe X2 par l'intermédiaire d'un moyeu 12. La température de la cible augmente fortement durant les mesures, à mesure où elle absorbe une partie de l'énergie qui lui est transmise par le faisceau F. Le moyeu 12 est donc avantageusement conçu pour limiter la dissipation de chaleur aux autres éléments du dispositif 1. Dans l'exemple illustré, le moyeu 12 comprend des moyens de centrage 13 et des moyens de maintien 14, 15. Les moyens de maintien comprennent une pince inférieure 14 et une pince supérieure 15, tous trois montés sur l'arbre 11. La pince inférieure 14 est montée solidaire en rotation avec l'arbre 11 de sorte qu'elle transmet intégralement et rigidement à la cible 2 le mouvement de rotation de l'arbre 11. Les pinces inférieure et supérieure 14,15 prennent respectivement appui sur une face inférieure et une face supérieure de la cible le long d'un bord intérieur 17. La pince supérieure 15 est disposée pour rendre, par pincement, la cible 2 solidaire de la pince inférieure 14, en rotation et en translation.

Les moyens de centrage sont formés d'une pièce 13 ajustée sur l'arbre, entre les pinces 14,15. La pièce comprend une partie annulaire 18 d'épaisseur réduite qui vient en appui contre le bord intérieur 16 de la cible 2.

La pince supérieure 15 et la pièce de centrage 13 sont démontables de l'arbre 11, notamment pour permettre le changement de la cible 2.

De préférence, le contact des pinces et de la pièce de centrage ne sont pas continues le long du bord intérieur 16, de sorte que cela limite la transmission thermique. Dans le même but, il est aussi prévu des vides de part et d'autre de la zone annulaire 18, entre celle-ci et chacune des pinces 14,15.

Comme particulièrement représenté à la figure 2, lorsque le faisceau incident F vient frapper la cible 2 à l'endroit d'un trou 7, la cible joue un rôle de filtre, de sorte que seule une partie filtrée dF du faisceau F, est diffusée au travers de la cible 2 par le trou 7. Du haut vers le bas, le trou illustré à la figure 2 a d'abord une portion cylindrique, puis une portion tronconique allant en s'élargissant fortement vers le bas. Une telle disposition est particulièrement avantageuse pour éviter une interception notable des électrons par les parois du trou 7.

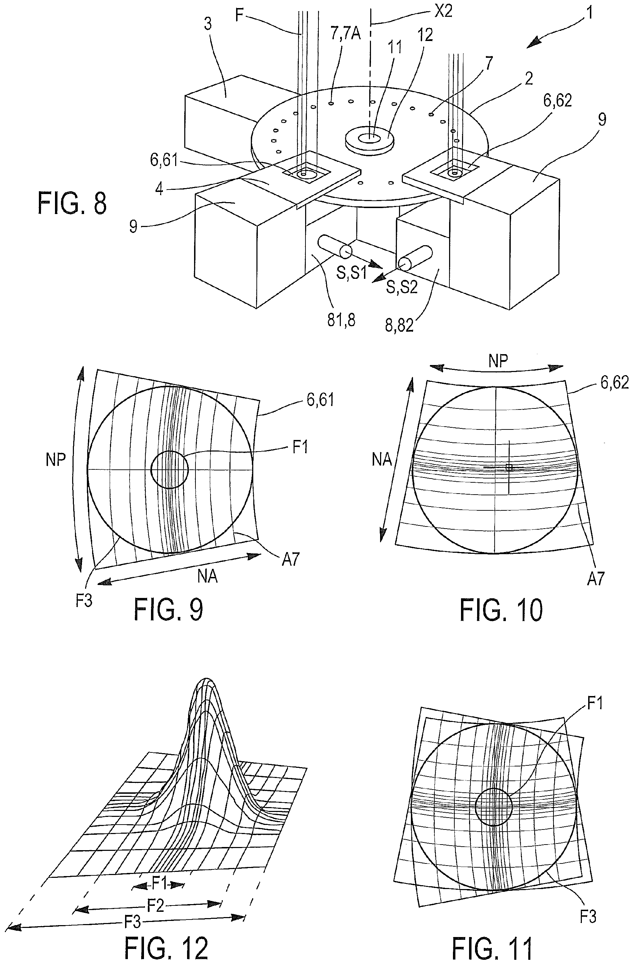

La cage de Faraday 8 est disposée sous la cible 2, en vis-à-vis de l'ouverture 6, de sorte que, quel que soit le trou 7 parcourant l'ouverture, la partie filtrée dF qu'il diffuse est toujours absorbée par la cage de Faraday. La cage de Faraday 8 a une configuration intérieure en forme de puits conique 8A de telle sorte que les électrons s'y trouvent piégés. Dans l'exemple illustré à la figure 8, les surfaces intérieures inclinées de la cage de Faraday permettent de minimiser les pertes d'électrons secondaires et rétrodiffusés. Ainsi, la cage de Faraday est construite de manière à collecter l'ensemble du courant de faisceau transmis par les trous d'aiguille tout en évitant au maximum la perte d'électron rétro diffusés ou secondaire.

Comme illustré à la figure 1, le dispositif 1 comprend une sortie S pour un signal électrique sensiblement proportionnel au flux instantané d'électrons absorbé par la cage de Faraday.

Dans l'exemple illustré, la cible 9 est une cible refroidie. Lors de son amorçage, le faisceau y est dévié le temps de se stabiliser, puis, après la mesure, le temps de son extinction. Ainsi, on limite le temps d'exposition de la cible tournante au temps nécessaire aux mesures.

Le dispositif 1, notamment formé par la cible motorisée 2, le moteur 3, la fenêtre 4, la cage de Faraday 8 et la cible d'amorçage 9, constitue donc un scanner pour le faisceau d'électrons F. Des moyens peuvent être prévus dans le dispositif 1 pour défléchir le faisceau incident F en direction de la cible d'amorçage. On peut aussi utiliser des moyens de déflexion prévus dans la source du faisceau F. Les moyens de déflexion peuvent être des moyens de champ magnétique.

Bien que non représentés aux figures, le dispositif 1 selon l'invention peut avantageusement comprendre des moyens d'acquisition pour le signal issu de la sortie S et des moyens de traitement pour ce signal; notamment, ces moyens peuvent respectivement comprendre un logiciel d'acquisition et un logiciel de traitement du signal spécifique. Un tel dispositif 1 peut en outre comprendre des moyens de commande pour le moteur et, s'il y a lieu, des moyens de commande pour les moyens de déflexion du faisceau incident F. De préférence, l'ensemble des opérations: rotation du disque, déclenchement de l'acquisition, amorçage et extinction du faisceau, déflection du faisceau, etc., est géré par un automate programmable.

Le dispositif peut aussi comprendre des moyens pour être déplacé selon plusieurs axes, de façon à être positionné relativement au faisceau F.

On va maintenant décrire des étapes successives de l'analyse du faisceau F à l'aide du dispositif illustré.

Dans un premier temps, la cible 2 étant en rotation, le faisceau est maintenu non défléchi et à faible puissance, en direction de la cible 2. Le centrage de l'ouverture 6 de la fenêtre 4, sur le faisceau non dévié, est vérifié puis éventuellement corrigé.

Ensuite, on défléchit le faisceau F vers la cible refroidie 9, le temps de son amorçage, c'est-à-dire le temps que le faisceau ait atteint sa puissance nominale et un équilibre thermique.

Ensuite, on arrête la déflexion du faisceau F, de sorte qu'il vient percuter la cible tournante2, dans une zone délimitée par la fenêtre 4, à l'intérieur de l'ouverture 6, tel qu'illustré aux figures 1 et 2; l'acquisition du signal S est déclenchée sensiblement simultanément. On laisse le faisceau ainsi dirigé pendant le temps nécessaire à la cible 2 pour faire deux révolutions; on recueille le signal S issu de la cage de Faraday 8 au cours de ces deux révolutions.

Enfin, on défléchit de nouveau le faisceau F en direction de la cible refroidie 9, le temps de son extinction.

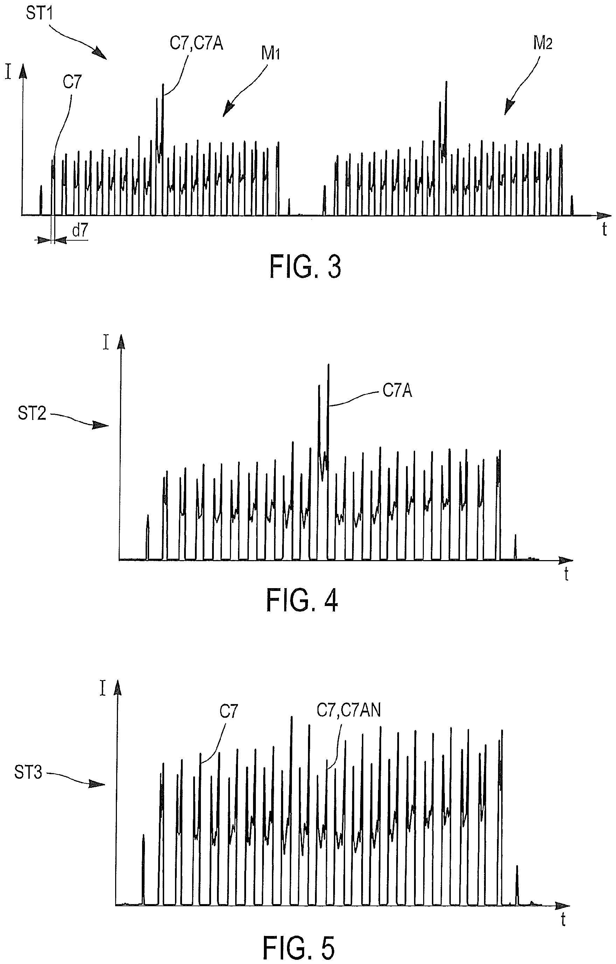

Le signal S peut être traité à mesure de son acquisition ou en différé après un enregistrement préalable. Les figures 3 à 5 illustrent un mode de traitement prévu pour le signal S. On notera que les figures 3, 4 et 5 ne sont pas aux mêmes échelles.

La figure 3 illustre un premier tracé ST1 représentant un profil d'intensité I mesurée en fonction du temps t. Le tracé ST1 peut être issu d'un premier traitement des valeurs du signal S mesuré durant les deux révolutions. On remarque que le tracé ST1 reproduit deux motifs M1, M2, correspondant respectivement aux première et deuxième révolutions. Chacun des motifs comprend une succession de crêtes C7 de durée d7 correspondant au parcours d'un trou 7 respectif au travers du faisceau F. La durée d7 est d'autant plus longue que l'arc de cercle parcouru par le trou 7 dans le faisceau F est plus proche du milieu du faisceau F. On note que la crête C7A, correspondant au repère 7A se présente comme une anomalie entres autres crêtes. En effet, la section du trou repère 7A étant sensiblement double de celle des autres trous 7, le nombre d'électrons le franchissant, donc l'intensité mesurée I, est sensiblement double. La présence de deux anomalies C7A sur le tracé ST1 permet de s'assurer que la mesure correspondante a bien été effectuée sur au moins une révolution, c'est-à-dire que l'ensemble des trous ont bien franchi l'ouverture 6 et que le faisceau a bien été entièrement scanné. Pour plus de clarté, le tracé ST1 est formé de deux motifs M1, M2 complets. Néanmoins, dans un cas général, le tracé ST1, s'il correspond à deux révoltions, est formé d'un premier motif partiel, d'un deuxième motif complet et d'un troisième motif partiel, complémentaire du premier.

La figure 4 illustre un deuxième tracé ST2. Le tracé ST2 est issu d'un deuxième traitement, appliqué aux valeurs du premier tracé ST1, de sorte que l'on ne conserve que les valeurs (t,I) représentatives d'une seule révolution. Ces valeurs représentatives peuvent, par exemple, être les valeurs exactes entre deux anomalies C7A successives, des moyennes des valeurs des deux motifs M1, M2, ou bien les valeurs exactes de l'un des motifs M1 ou M2. Le tracé ST2 comprend toutes les informations nécessaires à une analyse de répartition d'intensité à l'intérieur de la section scannée du faisceau F, sauf en ce qu'il faut corriger l'anomalie C7A. Le nombre d'acquisitions, c'est-à-dire le nombre de crêtes apparaissant, donc le nombre de trous 7 ayant franchi le faisceau est déterminé à l'aide des crêtes C7A successives; ceci rend la procédure moins dépendante de la vitesse de rotation de la cible 2.

La figure 5 illustre un troisième tracé ST3. Le tracé ST3 est issu d'un troisième traitement au cours duquel les valeurs de l'anomalie C7A sont normalisées, de sortent qu'elles correspondent à celles qui auraient été mesurées par un trou 7 de section courante. Dans le cas d'espèce, les valeurs de la crête C7A ont été divisées par 2. Ainsi, dans le tracé ST3, l'anomalie C7A est remplacée par une crête correspondante C7AN, dont les valeurs sont normalisées relativement à celle de l'anomalie C7A.

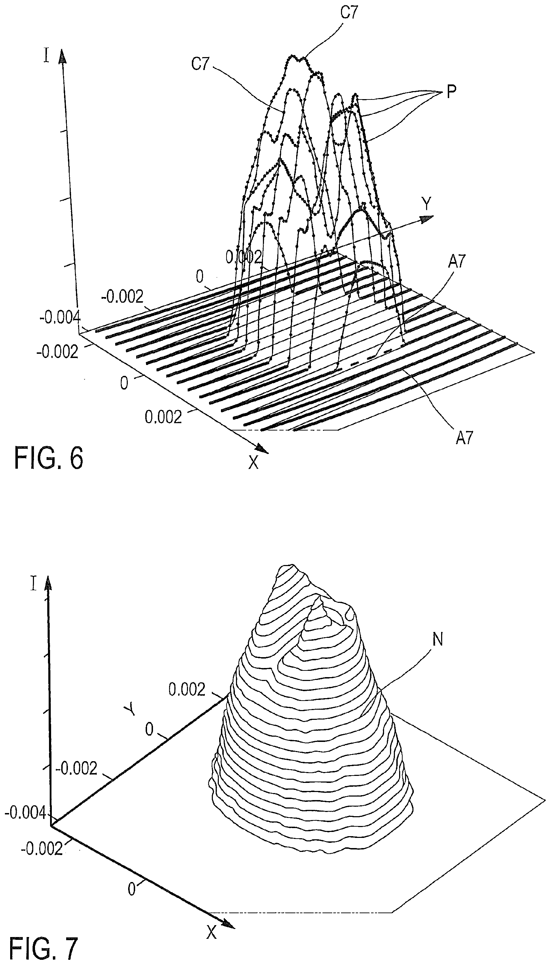

La figure 6 illustre une première reconstruction spatiale, c'est-à-dire une image en trois dimensions, des intensités I du tracé ST3 relativement à la position des mesures relativement à une portion de plan XY, dans laquelle la portion XY représente l'ouverture 6 de la fenêtre 4. Ainsi, la figure 6 est une reconstitution de la section analysée du faisceau F, et, pour chaque mesure effectuée, de l'intensité mesurée et de l'endroit de la section où cette intensité a été mesurée, relativement à la fenêtre 4. Dans cette première reconstruction spatiale, chaque crête C7 y est représentée de telle sorte que sa projection sur la portion de plan XY est un arc de cercle A7 correspondant au parcours du trou 7 respectif, en vis-à-vis de l'ouverture 6. La représentation de chaque crête y est discrétisée sous la forme de points P, puis reconstituée informatiquement à partir ce ces points P.

La figure 7 est une deuxième reconstruction spatiale des intensités I du tracé ST3, sensiblement identique à la représentation de la figure 6, sauf en ce que les valeurs d'intensité y ont été interpolées entre les courbes des crêtes C7; ainsi, les valeurs d'intensité y sont représentées par une surface continue et repérées par des courbes de niveau N. La figure 7 est donc une image de la répartition de densité de courant, donc de la répartition de la puissance, dans la section analysée du faisceau F; la section analysée étant celle en contact avec la surface supérieure de la cible 2. De préférence, la section analysée est au moins proche d'une section active du faisceau F lorsqu'il est utilisé, par exemple pour de la soudure.

Les étapes d'acquisition et de traitement du signal S, notamment celles illustrées aux figures 3 à 5, sont avantageusement automatisées. Une étape ultérieure, de calage de la machine émettrice du faisceau F, peut tout aussi avantageusement être automatisée. Cela peut être le cas si la machine est destinée au soudage de deux pièces entre elles; ainsi, le parcours du faisceau F peut être défini, en fonction d'une analyse de densité de courant préalablement effectuée, de sorte que la soudure soit optimisée.

On va maintenant décrire, en référence aux figures 8 à 12, un deuxième mode de réalisation pour un dispositif 1 selon l'invention, en ce qu'il diffère du dispositif précédemment décrit en référence aux figures 1 à 7.

Dans ce mode de réalisation, il y a deux dispositifs de détection, ici deux cages de Faraday 8 la deuxième cage de Faraday 82 étant disposées à 90 degrés, relativement à l'axe X2, de la première cage de Faraday 81, telle qu'illustrée à la figure 1. Les première et deuxièmes cages de Faraday sont disposées en vis-à-vis d'une première fenêtre 61 et d'une deuxième fenêtre 62, respectivement.

En outre, dans ce deuxième mode de réalisation, et comme particulièrement illustré aux figures 9 et 10, l'espacement radial entre chaque trou 7 de la cible 2, donc entre chaque parcours en forme d'arc A7 correspondant, varie. Dans l'exemple illustré, les arcs A7 sont d'autant plus resserrés entre eux qu'ils sont proches du milieu d'une fenêtre 6. Cette disposition est particulièrement avantageuse, puisqu'elle permet d'analyser indifféremment, avec la même cible tournante et avec une précision suffisante, des faisceaux de petit diamètre F1 (voir figures 9, 11 et 12), de diamètre moyen F2 ou de plus grand diamètre F3, sans augmenter de façon excessive le nombre de trous et de mesures, notamment dans le cas de faisceaux de grand diamètre F3. Ainsi, particulièrement, le dispositif 1 est avantageusement positionné de sorte qu'un faisceau fin, de type F1, soit analysé par les trous 7 situés dans la zone de la cible où leurs parcours A7 sont les plus resserrés.

Notamment lorsqu'une telle cible 2, à pas radial variable, est utilisée avec un dispositif 1 du premier mode de réalisation, tel qu'illustré à la figure 1, l'analyse présente un déséquilibre particulièrement prononcé, entre un nombre de mesures radiales correspondant aux nombres d'arcs NA et un nombre de points de mesures NP sur chaque arc, possibles au travers d'une fenêtre 6. Par exemple, on peut typiquement avoir, dans les exemples illustrés aux figures 9 à 11, NA=17 et 150<NP<200.

Grâce au deuxième mode de réalisation, et à l'utilisation des deux cages de Faraday 81,82 disposées à 90 degrés l'une de l'autre, on peut donc scanner, c'est-à-dire analyser, le faisceau F selon deux directions sensiblement perpendiculaires entre elles. A chaque analyse correspondent des parcours A7 respectivement illustrés par les figures 9 et 10. Ces parcours peuvent être superposés pour former un quadrillage de la section du faisceau F analysée; tel qu'illustré à la figure 11.

La figure 12 illustre la reconstruction d'une répartition des intensités dans le cas d'un faisceau diamètre moyen du type F2, à partir des signaux S, respectivement S1, S2 issus des première et deuxième cages de Faraday 81,82.

Dans l'exemple illustré en figure 8 il est prévu une cible d'amorçage 9 associée à chacune des cages de Faraday. Néanmoins, il peut n'être prévu qu'une seuls cible d'amorçage 9, par exemple disposée angulairement entre les deux cages de Faraday 81,82.

De préférence, il est prévu des moyens (non représentés aux figures) pour positionner le dispositif 1, avec une précision suffisante en regard de la précision recherchée pour l'analyse, de sorte que l'analyse soit toujours faite lorsque le faisceau F est non défléchi, que ce soit avec la première ou la deuxième cage de Faraday. Ainsi, on positionne la première fenêtre 61 dans l'axe du faisceau F non défléchi, puis, une première série de mesures étant faites, on déplace le dispositif pour positionner la deuxième fenêtre dans le même axe du faisceau non défléchi, avant d'effectuer une deuxième série de mesures.

Le positionnement est de préférence suffisamment précis pour pouvoir superposer directement les deux séries de mesures. Néanmoins, il peut être prévu une correction, par exemple en comparant des mesures qui auraient du être sensiblement identiques, notamment aux intersections des parcours, lors de la superposition.

Bien sûr, l'invention n'est pas limitée aux exemples qui viennent d'être décrits.

En particulier, si dans l'exemple illustré les mesures sont faites sur deux révolutions complètes, il est aussi possible de détecter une première et une deuxième apparition du pic de mesure correspondant au repère, et interrompre immédiatement la mesure après l'apparition du deuxième pic. On peut ainsi limiter l'exposition de la cible au faisceau.

Dans l'exemple illustré, le repère parcours une région du faisceau F qui lui est propre, c'est-à-dire que les mesures qui sont effectuées au travers dudit trou participent, après normalisation, à l'analyse. Néanmoins, le repère peut aussi être prévu pour parcourir une région déjà parcourue, ou pas, par un autre trou, de sorte que le repère ne participe plus à l'analyse, mais assure uniquement sa fonction de repère.

Le dispositif peut aussi comprendre des moyens pour mesurer des variations de vitesses sur disque au cours d'une analyse, de façon à pouvoir corriger ensuite les mesures effectuées en fonction de ces variations de vitesse.

Les trous peuvent être de forme uniquement tronconique, c'est-à-dire ne pas comprendre de portion cylindrique.

La cible tournante peut comprendre plusieurs séries de trous et chaque série former une spirale respective. Chacune de ces spirales peut être radialement décalée et avoir des trous de dimensions différentes par rapport à une autre. Dans ce cas, la cage de Faraday peut être de dimensions suffisantes pour être utilisée pour toutes les spirales. Une cage de Faraday spécifique peut aussi être prévue pour chacune des spirales. Chacune des spirales peut avoir une utilisation dédiée, par exemple, à un type de faisceau de diamètre ou d'intensités spécifiques, ou en fonction de la précision recherchée.

Les écartements angulaires entre les trous, relativement à l'axe, peuvent être réguliers ou pas. La distance radiale entre les trous peut aller en croissant ou en décroissant relativement à l'axe.

Un espacement radial ou angulaire irrégulier peut notamment permettre de traiter avec une même cible et une même spirale des faisceaux de caractéristiques différentes; par exemple, une portion de la spirale ayant un espacement large permettant d'analyser des faisceaux larges, tels des faisceaux naturel ou non focalisés, et une autre de la spirale ayant un espacement réduit permettant d'analyser des faisceaux fins. Ainsi, l'intervalle entre les trous peut, mais non limitativement, être plus grand en début et en fin de spirale, et, être plus petit dans une partie intermédiaire de la spirale, comme illustré dans le deuxième mode de réalisation.

Une table d'espacement des trous est avantageusement utilisée pour la reconstruction des intensités du faisceau, de sorte qu'un espacement irrégulier n'affecte pas le résultat. Si tout ou partie de l'irrégularité résulte de tolérance lors de l'usinage de la cible, elle peut ainsi être compensée par un relevé géométrique précis dont la table est le reflet.

Avantageusement, la cible rotative est interchangeable, par exemple pour pouvoir utiliser des cibles dont les trous ont un espacement, radial ou angulaire, et/ou, des diamètres, différents selon chaque cible, en fonction de la précision recherchée et/ou les dimensions transversales du faisceau à analyser.

## Revendications

1. Dispositif (1) d'analyse de la densité de courant dans un faisceau incident (F) de particules chargées, comprenant une cible mobile (2) en rotation autour d'un axe (X2), ladite cible étant prévue pour y projeter le faisceau (F) en cours d'analyse, plusieurs trous (7) traversant ladite cible mobile (2) et disposés de sorte que chaque trou (7) parcourt une section dudit faisceau selon un chemin respectif lorsque ladite cible (2) se déplace (7), et, des moyens (8) pour mesurer la densité de courant d'une fraction (dF) du faisceau incident (F) traversant ladite cible par ledit trou,
**caractérisé en ce que** les arcs de cercles parcourus par les trous (7) sont radialement plus proches dans une zone intermédiaire et radialement plus éloignés de part et d'autre de ladite zone intermédiaire.

2. Dispositif selon la revendication 1, **caractérisé en ce qu'**il comprend au moins un trou repère (7A), la section dudit trou repère (7A) étant notablement différente, de préférence double, de la section de l'au moins un trou (7).

3. Dispositif selon l'une des revendications 1 ou 2, **caractérisé en ce que** les trous (7) sont régulièrement angulairement espacés entre eux.

4. Dispositif selon l'une des revendications 1 à 3, **caractérisé en ce que** les moyens pour mesurer la densité de courant de la fraction (dF) comprennent au moins une cage de Faraday (8).

5. Dispositif selon l'une des revendications 1 à 4, **caractérisé en ce qu'**il comprend une cible d'amorçage (9), de préférence refroidie.

6. Dispositif selon la revendication 5, **caractérisé en ce qu'**il comprend des moyens pour défléchir le faisceau incident en direction de la cible d'amorçage (9).

7. Procédé d'analyse de la densité de courant dans une section d'un faisceau incident (F) de particules chargées, comprenant des étapes pour:
- mesurer un profil (ST1) de densité de courant dans des fractions (dF) du faisceau incident en faisant tourner une cible (2), percée de plusieurs trous (7), autour d'un axe (X2), entre le faisceau (F) et des moyens (8) pour mesurer la densité de courant dans des fractions (dF) instantanées dudit faisceau traversant un desdits trous (7) ; et,
- reconstruire la distribution de courant dans ladite section à partir dudit profil (ST1),
**caractérisé en ce que** les arcs de cercles (A7) parcourus par les trous (7) sont radialement plus proches dans une zone intermédiaire et radialement plus éloignés de part et d'autre de ladite zone intermédiaire.

8. Procédé selon la revendication 7, **caractérisé en ce que** les trous (7) sont régulièrement angulairement répartis, autour de l'axe (X2), les trous (7) ayant préférentiellement une section identique entre eux.

9. Procédé selon la revendication 8, **caractérisé en ce que** la cible comprend un trou repère (7A) ayant une section différente de celle des autres trous (7), de sorte que le parcours dudit repère (7A) dans la section analysée provoque une anomalie (C7A) dans le profil (ST1), et, **en ce que** l'on vérifie que l'analyse est complète en s'assurant que deux anomalies apparaissent dans ledit profil (ST1).

10. Procédé selon la revendication 9, **caractérisé en ce que** l'apparition de deux anomalies (C7A) successives permet de déterminer la vitesse de rotation réelle de la cible (2).

11. Procédé selon l'une des revendications 7 à 10, **caractérisé en ce qu'**il comprend en outre des étapes pour:
- positionner le faisceau (F), de préférence défocalisé, à faible courant et non défléchi, sur la cible tournante (2); puis,
- défléchir le faisceau en direction d'une cible d'amorçage (9); puis,
- augmenter la puissance du faisceau jusqu'à atteindre sa puissance nominale et un équilibre thermique dudit faisceau; puis,
- lorsque la vitesse de rotation de la cible tournante (2) est stabilisée, arrêter la déflection du faisceau; et,
- acquérir le profil pendant un temps donné, de préférence correspondant sensiblement à deux révolution de cible (2); puis,
- défléchir de nouveau le faisceau en direction de la cible d'amorçage (9); puis,
- éteindre le faisceau et arrêter la rotation de la cible (2).

12. Procédé selon l'une des revendications 7 à 11, **caractérisé en ce qu'**il comprend au moins une étape pour calculer au moins un paramètre du faisceau parmi la largeur à mi-hauteur, la largeur à la hauteur 1/e², la puissance surfacique maximale.

13. Procédé pour déterminer une usure d'une électrode d'un générateur de faisceau de particules chargées, **caractérisé en ce qu'**on utilise un procédé selon l'une des revendications 7 à 11.

14. Procédé pour déterminer un défaut d'alignement d'une électrode d'un générateur de faisceau de particules chargées, **caractérisé en ce qu'**on utilise un procédé selon l'une des revendications 7 à 11.

15. Procédé pour déterminer une focalisation optimale pour un faisceau de particules chargées, **caractérisé en ce qu'**on utilise un procédé selon l'une des revendications 7 à 11.

## Patentansprüche

1. Vorrichtung (1) für die Analyse der Stromdichte in einem einfallenden Strahl (F) geladener Partikel umfassend ein bewegliches, sich um eine Achse (X2) drehendes Target (2), wobei das Target dafür vorgesehen ist, den Strahl (F) während der Analyse darauf zu projizieren, mehrere Löcher (7), die durch das bewegliche Target (2) hindurchgehen und die so angeordnet sind, dass jedes Loch (7) einen Bereich des Strahls entlang eines jeweiligen Wegs durchläuft, wenn sich das Target (2) bewegt (7), und Mittel (8) zum Messen der Stromdichte einer Fraktion (dF) des einfallenden Strahls (F), die durch das Loch durch das Target hindurchtritt,
**dadurch gekennzeichnet, dass** die Kreisbögen, die von den Löchern (7) durchlaufen werden, in einer mittleren Zone radial näher sind und beiderseits der mittleren Zone radial weiter entfernt sind.

2. Vorrichtung nach Anspruch 1, **dadurch gekennzeichnet, dass** sie mindestens ein Bezugspunktloch (7A) umfasst, wobei der Querschnitt des Bezugspunktloches (7A) deutlich verschieden, vorzugsweise das Doppelte, von dem Querschnitt des mindestens einen Lochs (7) ist.

3. Vorrichtung nach einem der Ansprüche 1 oder 2, **dadurch gekennzeichnet, dass** die Löcher (7) winkelmäßig regelmäßig voneinander beabstandet sind.

4. Vorrichtung nach einem der Ansprüche 1 bis 3, **dadurch gekennzeichnet, dass** die Mittel zum Messen der Stromdichte der Fraktion (dF) mindestens einen Faraday-Käfig (8) umfassen.

5. Vorrichtung nach einem der Ansprüche 1 bis 4, **dadurch gekennzeichnet, dass** sie ein Starttarget (9) umfasst, das vorzugsweise gekühlt ist.

6. Vorrichtung nach Anspruch 5, **dadurch gekennzeichnet, dass** sie Mittel zum Ablenken des einfallenden Strahls in Richtung des Starttargets (9) umfasst.

7. Verfahren zum Analysieren der Stromdichte in einem Querschnitt eines einfallenden Strahls (F) geladener Partikel, das folgende Schritte umfasst:
- Messen eines Profils (ST1) der Stromdichte in Fraktionen (dF) des einfallenden Strahls, indem man ein Target (2), das von mehreren Löchern (7) durchbohrt ist, sich um eine Achse (X2) drehen lässt zwischen dem Strahl (F) und Mitteln (8) zum Messen der Stromdichte in augenblicklichen Fraktionen (dF) des Strahls, die eines der Löcher (7) passieren; und
- Rekonstruieren der Verteilung des Stroms in dem Querschnitt anhand des Profils (ST1),
**dadurch gekennzeichnet, dass** die Kreisbögen (A7), die von den Löchern (7) durchlaufen werden, in einer mittleren Zone radial näher sind und beiderseits der mittleren Zone radial weiter entfernt sind.

8. Verfahren nach Anspruch 7, **dadurch gekennzeichnet, dass** die Löcher (7) winkelmäßig regelmäßig um die Achse (X2) verteilt sind, wobei die Löcher (7) untereinander vorzugsweise einen identischen Querschnitt haben.

9. Verfahren nach Anspruch 8, **dadurch gekennzeichnet, dass** das Target ein Bezugspunktloch (7A) umfasst, das einen Querschnitt verschieden von dem Querschnitt der anderen Löcher (7) aufweist, so dass das Durchlaufen des Bezugspunktlochs (7A) in dem analysierten Querschnitt eine Anomalie (C7A) in dem Profil (ST1) hervorruft, und dass man überprüft, dass die Analyse vollständig ist, indem man sich vergewissert, dass in dem Profil (ST1) zwei Anomalien auftreten.

10. Verfahren nach Anspruch 9, **dadurch gekennzeichnet, dass** das Auftreten von zwei aufeinanderfolgenden Anomalien (C7A) die Ermittlung der tatsächlichen Drehgeschwindigkeit des Targets (2) ermöglicht.

11. Verfahren nach einem der Ansprüche 7 bis 10, **dadurch gekennzeichnet, dass** es außerdem folgende Schritte umfasst:
- Positionieren des Strahls (F), der vorzugsweise defokussiert ist, mit geringem Strom und nicht abgelenkt, auf dem sich drehenden Target (2); dann
- Ablenken des Strahls in Richtung eines Starttargets (9); dann
- Erhöhen der Leistung des Strahls bis zum Erreichen seiner nominalen Leistung und eines thermischen Gleichgewichts des Strahls; dann
- Beenden der Ablenkung des Strahls, wenn die Drehgeschwindigkeit des sich drehenden Targets (2) stabilisiert ist; und
- Aufnehmen des Profils während einer vorgegebenen Zeit, die vorzugsweise im Wesentlichen zwei Umdrehungen des Targets (2) entspricht; dann
- erneutes Ablenken des Strahls in Richtung des Starttargets (9); dann
- Abschalten des Strahls und Stoppen der Drehung des Targets (2).

12. Verfahren nach einem der Ansprüche 7 bis 11, **dadurch gekennzeichnet, dass** es mindestens einen Schritt zum Berechnen mindestens eines Parameters des Strahls, darunter die Halbwertbreite, die Breite bei der Höhe 1/e², die maximale Oberflächenleistung, umfasst.

13. Verfahren zum Ermitteln einer Abnutzung einer Elektrode eines Erzeugers eines Strahls geladener Partikel, **dadurch gekennzeichnet, dass** ein Verfahren nach einem der Ansprüche 7 bis 11 angewendet wird.

14. Verfahren zum Ermitteln eines Fehlers in der Justierung einer Elektrode eines Erzeugers eines Strahls geladener Partikel, **dadurch gekennzeichnet, dass** ein Verfahren nach einem der Ansprüche 7 bis 11 angewendet wird.

15. Verfahren zum Ermitteln einer optimalen Fokussierung eines Strahls geladener Partikel, **dadurch gekennzeichnet, dass** ein Verfahren nach einem der Ansprüche 7 bis 11 angewendet wird.

## Claims

1. Device (1) for analysing the current density in an incident beam (F) of charged particles, comprising a mobile target (2) rotating around an axis (X2), said target being provided to project the beam (F) there during analysis, several holes (7) crossing said mobile target (2) and arranged such that each hole (7) goes through a section of said beam along a respective path when said target (2) moves (7), and, means (8) for measuring the current density of a fraction (dF) of the incident beam (F) crossing said target by said hole,
**characterised in that** the circular arcs gone through by the holes (7) are radially closer in an intermediate zone and radially farther away from each other from said intermediate zone.

2. Device according to claim 1, **characterised in that** it comprises at least one indexing hole (7A), the section of said indexing hole (7A) being notably different, preferably double, of the section of the at least one hole (7).

3. Device according to one of the claims 1 or 2, **characterised in that** the holes (7) are regularly angularly spaced out.

4. Device according to one of the claims 1 to 3, **characterised in that** the means for measuring the current density of the fraction (dF) comprise at least one Faraday cage (8).

5. Device according to one of the claims 1 to 4, **characterised in that** it comprises an initiation target (9), preferably cooled.

6. Device according to claim 5, **characterised in that** it comprises means for deflecting the incident beam in the direction of the initiation target (9).

7. Method for analysing the current density in a section of an incident beam (F) of charged particles, comprising steps for:
- measuring one profile (ST1) of current density in fractions (dF) of the incident beam by making a target (2) turn, pierced with several holes (7), around an axis (X2), between the beam (F) and the means (8) for measuring the current density in the fractions (dF) instantaneously from said beam crossing one of said holes (7)? and,
- reconstructing the current distribution in said section from said profile (ST1),
**characterised in that** the circular arcs (A7) gone through by the holes (7) are radially closer in an intermediate zone and radially farther away from each other from said intermediate zone.

8. Method according to claim 7, **characterised in that** the holes (7) are regularly angularly spread out, around an axis (X2), the holes (7) preferably having an identical section to each other.

9. Method according to claim 8, **characterised in that** the target comprises an indexing hole (7A) that has a different section from that of the other holes (7), such that the path of said indexing hole (7A) in the section analysed leads to an anomaly (C7A) in the profile (ST1), and, **in that** it is checked that the analysis is complete by ensuring that two anomalies appear in said profile (ST1).

10. Method according to claim 9, **characterised in that** the appearance of two successive anomalies (C7A) enables to determine the actual rotating speed of the target (2).

11. Method according to one of the claims 7 to 10, **characterised in that** it further comprises steps for:
- positioning the beam (F), preferably defocused, at a low current and non-deflected, on the turning target (2); then,
- deflecting the beam in the direction of an initiation target (9); then,
- increasing the power of the beam until it reaches the nominal power thereof and a thermal balance of said beam; then,
- when the rotating speed of the turning target (2) is stabilised, stopping the deflection of the beam; and,
- acquiring the profile during a given time, preferably substantially corresponding to two target (2) revolutions; then,
- deflecting the beam again in the direction of the initiation target (9); then,
- switching off the beam and stopping the rotation of the target (2).

12. Method according to one of the claims 7 to 11, **characterised in that** it comprises at least one step for calculating at least one parameter of the beam among the width at mid-height, the width at the height 1/e², the maximum surface power.

13. Method for determining wear and tear of an electrode of a charged particle beam generator, **characterised in that** a method according to one of the claims 7 to 11 is used.

14. Method for determining an alignment fault of an electrode of a charged particle beam generator, **characterised in that** a method according to one of the claims 7 to 11 is used.

15. Method for determining an optimal focalisation for a charged particle beam, **characterised in that** a method according to one of the claims 7 to 11 is used.
